# EUROPÄISCHE PATENTSCHRIFT

(11) **EP 0 595 117 B1**
(45) Veröffentlichungstag und Bekanntmachung des Hinweises auf die Patenterteilung: **13.05.1998**
(21) Anmeldenummer: 93116597.1
(22) Anmeldetag: 14.10.1993
(51) Int. Cl.: G01N 27/72, G01N 27/82, G01N 27/90, G01B 13/12, G01L 1/12

(54) **Vorrichtung zum ortsaufgelösten, zerstörungsfreien Untersuchen von magnetischen Kenngrössen**
Device for spatially resolved and non-destructive inspection of magnetic parameters
Appareil pour l'examen non-destructif avec résolution spatiale des paramètres magnétiques

(30) Priorität: 21.10.1992 DE 4235387; 22.12.1992 DE 4243532
(43) Veröffentlichungstag der Anmeldung: 04.05.1994
(73) Patentinhaber: FRAUNHOFER-GESELLSCHAFT ZUR FÖRDERUNG DER ANGEWANDTEN FORSCHUNG E.V., 80636 München (DE)
(72) Erfinder: Altpeter, Iris, 66123 Saarbrücken (DE); Theiner, Werner, 66123 Saarbrücken (DE); Gessner, Melanie, D-66646 Marpingen (DE)
(74) Vertreter: Rackette, Karl, Dipl.-Phys. Dr.-Ing

(56) Entgegenhaltungen:
- EP-A- 0 100 009
- EP-A- 0 241 013
- EP-A- 0 394 158
- WO-A-88/04047
- WO-A-92/01567
- US-A- 2 351 944
- US-A- 4 854 156
- PHILIPS TECHNICAL REVIEW, Bd.44, Nr.5, November 1988, EINDHOVEN NL Seiten 151 - 160 J.P.M. VERBUNT: 'Laboratory-scale manufacture of magnetic heads'

## Beschreibung

Die Erfindung betrifft eine Vorrichtung zum ortsaufgelösten, zerstörungsfreien Untersuchen von magnetischen Kenngrößen eines Prüfkörpers mit einem mit einer Positioniervorrichtung in einem Abstand in bezug auf den Prüfkörper positionierbaren Induktionssensor, der aus einem ferromagnetischen Kern mit zwei Kernteilen und mindestens einer Induktionsspule aufgebaut ist, wobei die Kernteile des Induktionssensors wenigstens im äußeren Mündungsbereich eines mit einem Einkoppelspalt ausgebildeten Einkoppelbereiches spitzenartig zulaufen.

Eine derartige Vorrichtung ist aus der EP-A-0 241 013 bekannt. Die gattungsgemäße Vorrichtung verfügt über einen Induktionssensor, der zwei wenigstens im äußeren Mündungsbereich eines mit einem Luftspalt als Einkoppelspalt ausgebildeten Einkoppelbereiches spitzenartig zulaufende Kernteile aufweist. Um jeden Kernteil ist eine Induktionsspule gewickelt. Mit der gattungsgemäßen Vorrichtung sind bei relativen Bewegungen des Induktionssensors in bezug auf einen Prüfkörper Mikrodefekte wie Haarrisse an der Oberfläche dadurch detektierbar, daß bei Beaufschlagen der Induktionsspulen mit einer Wechselspannung von mehr als 1 Megahertz die Differenz zwischen den aufsummierten Impedanzen jeder Spule gebildet werden. Bei Abwesenheit von Mikrodefekten ist diese Differenz Null, während bei Eintritt eines Haarrisses in den Erfassungsbereich des Luftspaltes die Differenz von Null verschieden wird.

Aus der US-A-2 351 944 ist eine weitere Vorrichtung zum ortsaufgelösten, zerstörungsfreien Untersuchen von magnetischen Kenngrößen bekannt, die über einen einen schmalen Einkoppelspalt aufweisenden Induktionssensor aus mit Induktionsspulen umwickelte Kernteile verfügt. Mit dem Induktionssensor sind durch Haarrisse hervorgerufene Streufelder eines durch ein Gleichstromfeld transversal magnetisierten zylindrischen Prüfkörpers detektierbar, während kontinuierliche Änderungen der Permeabilität aufgrund struktureller mechanischer Zugkräfte und/oder Druckkräfte nicht erfaßbar sind.

Aus dem Artikel von J. P. M. Verbunt, Laboratory scale manufacture of magnetic heads, in Philips Technical Review 44 (1988), Nr. 5, Seiten 151 bis 160, sind verschiedene aus Kernteilen aufgebaute Induktionssensoren mit sehr fein ausgebildeten Einkoppelspalten bekannt.

Aus der WO 92/01567 ist eine Steuereinrichtung für eine Funkenentladungsschreibeinheit bekannt, mit der ein Schreibkopf in einem konstanten Abstand von einem zu beschreibenden Gegenstand positionierbar ist.

Aus der WO 88/04047 ist eine Vorrichtung mit einer Tunnelmikroskopeinrichtung zur Erzeugung und Detektion von magnetischen Materialstrukturen im Bereich atomarer Dimensionen bekannt, die über einen Taster mit einer magnetisch wirksamen Abtastspitze verfügt. Ferner sind steuerbare Bewegungs- und Positioniervorrichtungen zum gegenseitigen Annähern zwischen Materialoberfläche und der Abtastspitze einerseits und der Abtastspitze und einer Tunnelspitze andererseits bis auf Nanometerdistanz vorgesehen. Als Meßsignale sind die relativen Auslenkungen der Abtastspitze gegenüber der Materialoberfläche während des rasterförmigen Abtastens derselben gebildet. Dadurch lassen sich magnetische Strukturen im atomaren Bereich herstellen und reproduzierbar auffinden.

Aus der US-A-4 854 156 ist eine Vorrichtung bekannt, mit der ein Wirbelstromsensor in einer vorbestimmten Distanz von einem Prüfkörper haltbar ist, wobei als Abstandsmesser eine Pneumatikeinheit vorgesehen ist. Mit der Pneumatikeinheit ist ein Luftstrom von einer ersten Kammer in eine zweite Kammer und von dieser auf das Werkstück richtbar. Da der Innendruck der zweiten Kammer von dem Abstand zu dem Prüfkörper abhängig ist, ist daraus ein Regelsignal zum Konstanthalten des Abstandes gewinnbar.

Aus der EP-A-0 100 009 ist eine Vorrichtung zum Messen von Werkstoffeigenschaften bekannt, bei der ein Induktionssensor in Aufsatztechnik über einen Prüfkörper führbar ist, um entweder das magnetinduktive Barkhausenrauschen in einzelnen Frequenzbändern mit jeweils entsprechend der gewünschten Analysiertiefe gewählten Mittenfrequenz oder die Überlagerungspermeabilität mit wählbarer Meßfrequenz zu messen. Bei dieser Vorrichtung ist der Induktionssensor als Luftspule oder als Tonbandkopf ausgebildet, mit dem lediglich verhältnismäßig großflächige makroskopische Bereiche des Prüfkörpers erfaßbar sind.

Eine weitere Vorrichtung zum ortsaufgelösten, zerstörungsfreien Untersuchen von magnetischen Kenngrößen ist aus der SU 1 068 850 A bekannt. Die Kernteile des Induktionssensors sind über einen mittig rechtwinklig auf beiden Kernteilen stehenden Verbindungssteg miteinander verbunden. Die Abmessungen des einem Prüfkörper zugewandten Einkoppelbereiches eines aus den zwei Kernteilen gebildeten Kernes sind durch die Größe der Kernteile sowie durch die Länge des Verbindungssteges festgelegt. Die Länge des Verbindungssteges liegt durch die Dimension der aufgewickelten Spule im makroskopischen Bereich von Millimetern bis Zentimetern. Aus diesem Grund ist die lokale Oberflächen¶ auflösung, die mit einem derartigen Induktionssensor erreichbar ist, verhältnismäßig groß und erlaubt insbesondere nicht die Untersuchung von Mikrostrukturen.

Eine weitere Vorrichtung zum ortsaufgelösten, zerstörungsfreien Untersuchen von magnetischen Kenngrößen ist aus 1. Altpeter: "Spannungsmessung und Zementitgehaltsbestimmung in Eisenwerkstoffen mittels dynamischer magnetischer und magnetoelastischer Meßgrößen", IzfP-Bericht Nr. 900111-TW, Saarbrücken, 1990, bekannt. Diese Vorrichtung weist als Induktionssensor zur Messung der Rauschmagnetfelder einen Tonbandkopf auf, mit dessen Hilfe in Aufsatztechnik ortsaufgelöste Eigenspannungsmessungen an der Oberfläche einer Niederdruckturbinenschaufel aus dem Material X20Cr13 durchführbar sind. Eine Positioniervorrichtung erlaubt das Verfahren des Tonkopfes entlang einer Meßspur. Die lokale Oberflächenauflösung bei der zerstörungsfreien Eigenspannungsmessung beträgt je nach verwendeter Meßspule 1 mm² bis 50 mm². Mit dieser Vorrichtung ist somit keine Auflösung der Mikrospannungszustände, der sogenannten Eigenspannungen zweiter Art, des untersuchten ferritischen Materials erreichbar. Aber gerade dies ist zur Ermittlung des Einflusses der Mikrospannungszustände eines Werkstückes bezüglich dessen mechanischer Belastbarkeit von großer Bedeutung, weil nicht geklärt ist, wie Mikrospannungen zur Ausbildung von Mikro- und Haarrissen beitragen.

In einer weiteren, im erwähnten Bericht beschriebenen Vorrichtung wird zur Untersuchung von Zementit in Stählen sowie in weißem Gußeisen als Induktionssensor anstelle des Tonkopfes eine Luftinduktionsspule verwendet, die einen zylindrischen Prüfkörper umschließt. Mit dieser Anordnung können allerdings nur integrale, d.h. über den Prüfkörper gemittelte Meßwerte gewonnen werden. Durch das Messen von Barkhausenrauschkurven in verschiedenen Frequenzbereichen und bei verschiedenen Temperaturen der Prüfkörper sind der Gefügezustand und der Zementitgehalt sowie die Struktur des Mikrogefüges indirekt ermittelbar. Insbesondere sind aber auch hier die makroskopischen und mikroskopischen Eigenspannungseinflüsse nicht unterscheidbar.

Der Erfindung liegt die Aufgabe zugrunde, eine Vorrichtung der eingangs genannten Art zu schaffen, die eine zerstörungsfreie, ortsaufgelöste Untersuchung des Makro- und Mikroeigenspannungszustandes, des Mikrogefügezustandes im oberflächennahen Bereich als auch die Detektion örtlicher Permeabilitäts- und Leitfähigkeitsänderung sowie die Detektion von Mikrofehlern von Prüfkörpern gestattet.

Diese Aufgabe wird erfindungsgemäß dadurch gelöst, daß die Abmessungen des Einkoppelspaltes höchstens im Bereich der Dimension von zu untersuchenden, durch Blochwände begrenzten Mikrostrukturen des Prüfkörpers liegen, daß ein Abstandsmesser zum Messen des Abstandes zwischen dem Induktionssensor und der Oberfläche des Prüfkörpers vorgesehen ist, daß ein Abstandsstellglied vorgesehen ist, mit dem der Abstand zwischen dem Induktionssensor und der Oberfläche des Prüfkörpers durch Beaufschlagen mit dem Ausgangssignal eines Reglers beim Positionieren des Induktionssensors konstanthaltbar ist, daß ein Erregungsmagnet und ein Wechselstromgenerator vorgesehen sind, mit denen ein Erregungsmagnetfeld generierbar ist, welches den Prüfkörper zum Erzeugen großflächiger, niederfrequenter Wirbelströme durchsetzt, daß eine Impedanzmeßvorrichtung vorgesehen ist, die einen Hochfrequenzgenerator umfaßt, welcher gegenüber dem Erregungsmagnetfeld hochfrequentere, wirbelstrominduzierte Magnetfelder erzeugen kann, die über den Einkoppelspalt aufnehmbar sind, daß ein Speicher und ein Diskriminator zur Bestimmung wenigstens eines für eine aufgenommene Barkhausenrauschkurve charakteristischen Wertes vorgesehen sind und daß die Impedanzmeßvorrichtung über eine von den höherfrequenten, wirbelstrominduzierten Magnetfeldern gespeiste Auswerteeinheit verfügt, mit der die von der Permeabilität und der Leitfähigkeit des Prüfkörpers abhängige Wirbelstromimpedanz erfaßbar ist.

Dadurch, daß bei der erfindungsgemäßen Vorrichtung der Einkoppelspalt im Bereich der Dimension von zu untersuchenden, durch Blochwände begrenzten Mikrostrukturen des Prüfkörpers liegen und mit dem derart ausgebildeten, sehr genau ortsauflösenden Induktionssensor wirbelstrominduzierte Magnetfelder aufnehmbar und daraus abgeleitete Prüfarößen weiterverarbeitbar sind.

Bei einem bevorzugten Ausführungsbeispiel der Erfindung ist durch das Anbringen von Kernvorsprüngen beidseitig des Einkoppelspaltes der Abstand zwischen den nicht an den Einkoppelspalt angrenzenden Kernbereichen und der Prüfkörperoberfläche erhöht, ohne daß der Kern des Induktionssensors selbst spitzenartig ausgebildet ist. Derartige Kernvorsprünge können selbstverständlich auch den Abstand zwischen dem Mündungsbereich des Einkoppelspaltes und den davon weiter entfernt liegenden Bereichen eines bereits spitzenartig zulaufenden Kerns vergrößern.

Durch beidseitige Ausnehmungen ist in den Kernteilen neben einem Rückschlußspalt sowie deren Verfüllung mit einem nicht ferromagnetischen Stoff, wie beispielsweise Glas, der magnetische Widerstand des Kerns zur Optimierung der Ausgangssignalstärke des Induktionssensors bei der Herstellung in einfacher Weise durch die Formgebung der Ausnehmungen beeinflußbar. Vorzugsweise ist die Induktionsspule in Wickelnuten und in einem Wickelraum um die Kernteile gewickelt. Es ist zweckmäßig, die Kernteile aus Ferrit herzustellen und den Kern bis auf den Bereich um den Einkoppelspalt mit einem Abschirmgehäuse aus einer Metallegierung mit einer hohen Anfangspermeabilität und einer kleinen Koerzitivkraft wie beispielsweise Mumetall zur Unterdrückung von Störeinkopplungen zu umgeben.

Als Abstandsmesser ist in einem Ausführungsbeispiel eine Anordnung mit einer druckluftdurchströmten, auf die Oberfläche des Prüfkörpers gerichteten Düse und einem statischen Druckmesser vorgesehen. Die Ausströmdynamik ist bei kleinen Abständen zwischen dem Düsenende und der Prüfkörperoberfläche sehr empfindlich von diesem Abstand abhängig. Die Sonde des statischen Druckmessers ist im Randbereich eines Zuleitungsrohres angebracht. Das Ausgangssignal des Druckmessers ist bei bekanntem Abstand zwischen der Spitze des Induktionssensors und dem Düsenende über den statischen Druck eindeutig mit dem Meßabstand korreliert. Die Düse ist zweckmäßigerweise im Bereich des Induktionssensors angebracht, so daß auch kleinflächige Unebenheiten der Prüfkörperoberfläche bei der Meßabstandsbestimmung erfaßbar sind. Der auf die Prüfkörperoberfläche gerichtete Luftstrom dient neben der Abstandsmessung zusätzlich auch zum Verblasen störender Staubteilchen.

Zum Erreichen einer hohen Induktionsspannung ist der Induktionssensor mit möglichst geringem Meßabstand über der Prüfkörperoberfläche geführt. Da das Messen magnetischer Kenngrößen sehr abstandssensitiv ist, weist das Abstandsstellglied zum präzisen Einstellen des Abstandes zwischen Induktionssensor und Prüfkörperoberfläche Piezokristalle auf.

Weitere Ausführungsbeispiele und Vorteile der Erfindung ergeben sich aus den Unteransprüchen und der nachfolgenden Beschreibung. Es zeigen:
- Fig. 1: einen erfindungsgemäßen Induktionssensor in schematischer, perspektivischer Ansicht,
- Fig. 2: einen Meßkopfhalter mit einem daran angebrachten Induktionssensor und einer Düse in schematischer Frontansicht,
- Fig. 3: einen Meßkopfhalter mit einem daran angebrachten Induktionssensor und einer Düse in schematischer Seitenansicht,
- Fig. 4: eine schematische, zum Teil perspektivische Darstellung eine Vorrichtung zum ortsaufgelösten Untersuchen des magnetischen Barkhausenrauschens, die zur Erläuterung der Erfindung dient, jedoch kein Ausführungsbeispiel darstellt,
- Fig. 5: ein Beispiel für eine Hysteresekurve mit einer zugehörigen magnetischen Barkhausenrauschkurve,
- Fig. 6: in einer schematischen Darstellung ein Ausführungsbeispiel einer Vorrichtung zum ortsaufgelösten Untersuchen von Wirbelstromimpedanzen mit einer Impedanzmeßvorrichtung, mit der ein hochfrequentes Wechselspannungsfeld über den Induktionssensor in einen Prüfkörper einkoppelbar ist, und
- Fig. 7: ein abgewandeltes Ausführungsbeispiel der in Fig. 6 dargestellten Vorrichtung, mit der das hochfrequente Wechselspannungsfeld über einen Erregungsmagneten in den gesamten Prüfkörper einkoppelbar ist.

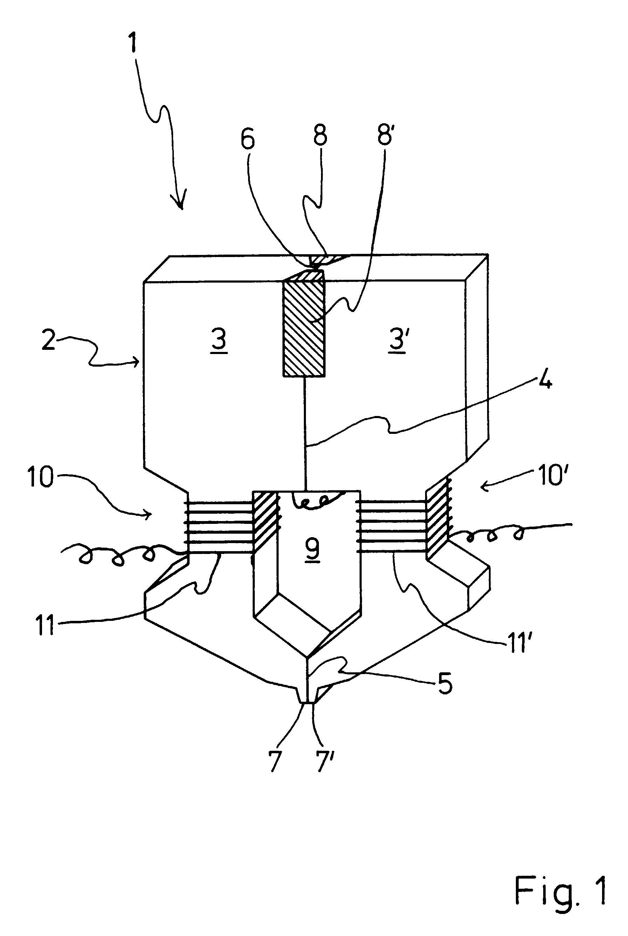

Fig. 1 zeigt schematisch in perspektivischer Ansicht einen erfindungsgemäßen Induktionssensor 1. Der Kern 2 des Induktionssensors 1 besteht aus zwei Kernteilen 3, 3' aus Ferrit, die durch einen durchgehenden Spalt 4 voneinander getrennt sind. Die zwei äußeren Mündungsbereiche des Spaltes 4 sind auf der einen Seite als Einkoppelspalt 5 und auf der anderen Seite als Rückschlußspalt 6 ausgeführt. Die Breite des Einkoppelspaltes 5 beträgt in diesem Ausführungsbeispiel im äußeren Mündungsbereich etwa 0,3 Mikrometer. In einem abgewandelten Ausführungsbeispiel des Induktionssensors 1 beträgt die Breite des Einkoppelspaltes 5 etwa 5 Mikrometer, so daß bei einer gegenüber dem vorgenannten Ausführungsbeispiel verringerten Ortsauflösung eine größere Tiefenauflösung und örtliche Mittelung erreicht ist.

Beidseitig neben dem Einkoppelspalt 5 sind auf den spitzenartig zulaufenden Kernteilen 3, 3' zusätzlich Kernteilvorsprünge 7, 7' angebracht. Die Kernteilvorsprünge 7, 7' liegen im wesentlichen in Verlängerung des Einkoppelspaltes 5. Sie erhöhen den Abstand zwischen der in Fig. 1 nicht dargestellten Prüfkörperoberfläche und dem nicht im Bereich des Einkoppelspaltes befindlichen Kernmaterial. Eine die Ortsauflösung des Induktionssensors 1 herabsetzende Einkopplung von Rauschmagnetfeldern in von dem Einkoppelspalt 5 entfernte Kernbereiche ist meßtechnisch nicht von Bedeutung, da diese durch die vorstehenden Kernteilvorsprünge außerhalb des wirksamen Wechselwirkungsabstandes liegen. Die Ortsauflösung des Induktionssensors 1 ist somit im wesentlichen durch die Geometrie des Einkoppelspaltes 5 bestimmt.

Die Kernteile 3, 3' weisen im Bereich des Rückschlußspaltes 6 Ausnehmungen 8, 8' auf, die mit Glas verfüllt sind. Zwischen dem Einkoppelspalt 5 und dem Rückschlußspalt 6 sind ein Wickelraum 9 und zwei Wickelnuten 10, 10' vorgesehen, in der die Wicklungen zweier Induktionsspulen 11, 11' liegen.

Der Induktionssensor 1 ist vorteilhafterweise mit einem in Fig. 1 nicht dargestellten Abschirmgehäuse aus Mumetall umgeben. Das Abschirmgehäuse kapselt den Induktionssensor 1 bis auf den äußeren Mündungsbereich des Einkoppelspaltes 5 von Störeinkopplungen ab. Dadurch ist sichergestellt, daß die Induktionsspulen 11, 11' keine elektromagnetischen Flußänderungen außer den über den Einkoppelspalt 5 eingekoppelten empfangen. Die Blechdicke ist so dimensioniert, daß die Amplituden der elektromagnetischen Wechselfelder im Frequenzbereich zwischen etwa 100 Hertz und etwa 10 Megahertz um mehr als 60 dB abschwächbar sind. Dadurch sind das Nutzsignal, die Nachweisempfindlichkeit sowie die Ortsauflösung verbesserbar.

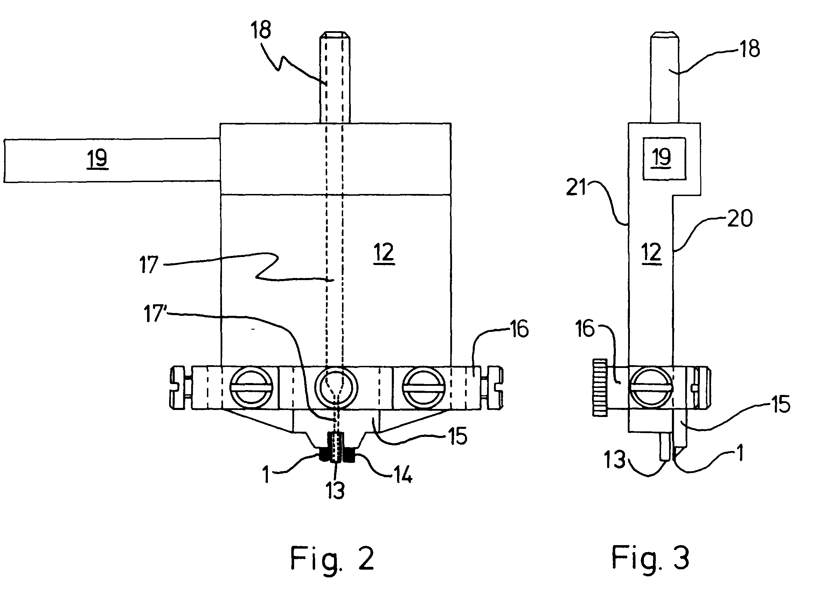

Fig. 2 zeigt in schematischer Frontansicht einen Meßkopfhalter 12 mit einem daran angebrachten Induktionssensor 1, einer Düse 13 und einer als Erregungsmagnetfeldsensor dienenden Hallsonde 14. Der Induktionssensor 1 und die Hallsonde 14 sind an zwei über die Abschlußkante des Meßkopfhalters 12 hinausragenden Enden einer Trägerplatte 15 befestigt. Ein Klemmbügel 16 befestigt die Trägerplatte 15 an dem Meßkopfhalter 12. Die Düse 13 ist im wesentlichen mittig zwischen dem Induktionssensor 1 und der Hallsonde 14 angeordnet. In dem Meßkopfhalter 12 sind Bohrungen 17, 17' vorgesehen, welche die Düse 13 mit einem Rohr 18 verbinden. Eine Haltestange 19 ist seitlich an dem Meßkopfhalter 12 befestigt.

Fig. 3 zeigt in einer schematischen Seitenansicht die Anordnung gemäß der Fig. 2. Der Induktionssensor 1 und die in dieser Abbildung nicht sichtbare Hallsonde sind im wesentlichen in Verlängerung der Frontfläche 20 des Meßkopfhalters 12 angebracht. Die Düse 13 sitzt zwischen den beiden über die Abschlußkante des Meßkopfhalters hinausragenden Enden der Trägerplatte 15 und ist in Richtung auf die Rückseite 21 des Meßkopfhalters 12 versetzt.

Weist die zur Messung ausschließlich benutzte Tangentialkomponente des Erregungsmagnetfeldes nur einen relativ kleinen homogenen Bereich auf, so ist es zweckmäßig, daß der Induktionssensor 1 und die Hallsonde 14 möglichst eng nebeneinanderliegen. Dadurch ist sichergestellt, daß die Hallsonde 14 tatsächlich die am Meßort herrschende Tangentialkomponente der Erregungsmagnetfeldstärke mißt.

Das Ende der Düse 13 liegt vorzugsweise in einer Ebene mit der Spitze des Induktionssensors 1. Da der Abstand zwischen dem Einkoppelspalt 5 des Induktionssensors 1 und der Prüfkörperoberfläche vorzugsweise sehr klein ist, kann das Ende der Düse 13 auch geringfügig hinter die Spitze des Induktionssensors 1 zurücktreten, so daß der kleinstmögliche Meßabstand zwischen dem Induktionssensor 1 und der Prüfkörperoberfläche nicht durch ein über die Spitze des Induktionssensors 1 hinausragendes Ende der Düse 13 eingeschränkt ist.

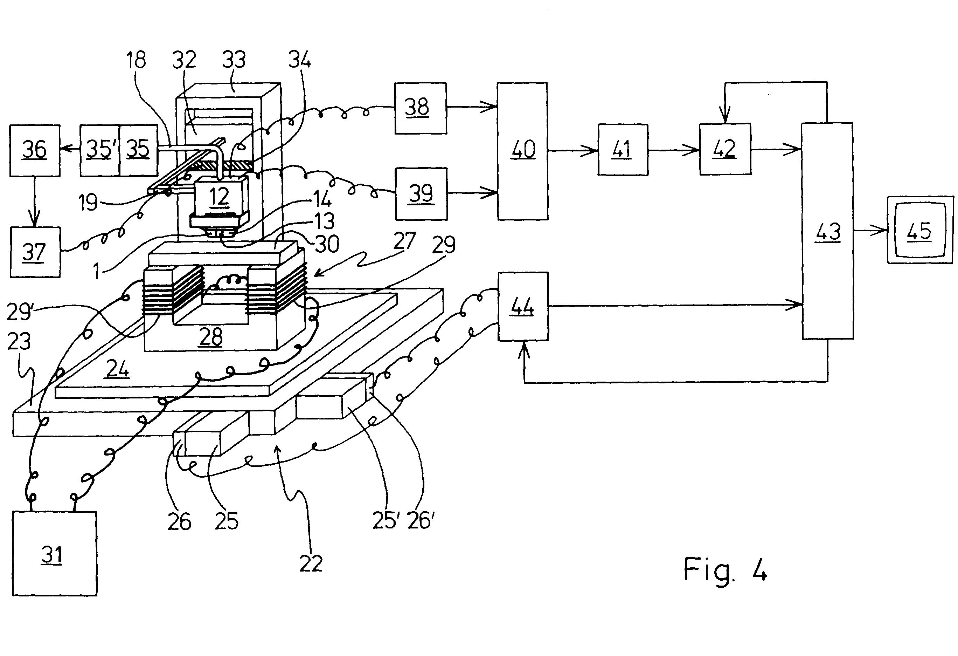

In Fig. 4 (nicht Teil des Erfindung) ist schematisch eine Meßapparatur sowie das Blockschaltbild einer Meßdatenerfassungeinrichtung zum ortsaufgelösten Untersuchen des magnetischen Barkhausenrauschens dargestellt. Eine Positioniervorrichtung 22 besteht im wesentlichen aus einer Grundplatte 23, auf der eine in zwei rechtwinklig zueinander verlaufenden Richtungen bewegliche Montageplatte 24 angebracht ist. Die Verschiebung der Montageplatte 24 erfolgt durch zwei Gleichstrommotoren 25, 25', die über zugehörige Motorsteuerungen 26, 26' ansteuerbar sind.

Auf der Montageplatte 24 ist ein Erregungsmagnet 27 befestigt. Der Erregungsmagnet 27 besteht im wesentlichen aus einem U-förmigen Joch 28 aus Eisenblechen, auf dessen Schenkel zwei Spulen 29, 29' aus isoliertem Kupferdraht gewickelt sind. Ein Prüfkörper 30 ist auf den Stirnflächen der Schenkel des Jochs 28 befestigt. Der Prüfkörper 30 ist in diesem Ausführungsbeispiel ein Eisenwerkstoff mit Zementitlamellen in einer Ferritmatrix. Die Breite der Zementitlamellen liegt typischerweise im Bereich von wenigen Mikrometern.

Die in Reihe geschalteten Spulen 29, 29' sind an einen Wechselstromgenerator 31 angeschlossen. Der in den Spulen 29, 29' mit beispielsweise sinusartiger Zeitabhängigkeit fließende Wechselstrom erzeugt in dem Joch 28 ein zeitlich veränderliches Erregungsmagnetfeld, das den auf dem Joch aufliegenden Prüfkörper 30 durchsetzt. Der Durchstimmbereich des Erregungsmagnetfeldes ist durch die Wahl der Maximalstromstärken veränderbar. Vorzugsweise ist der Erregungsspulenstrom zwischen einem positiven und einem negativen Wert mit jeweils gleichen Beträgen moduliert.

Der Meßkopfhalter 12 ist über die Haltestange 19 an einem Schlitten 32 eines Verschiebetisches 33 angebracht. Der Schlitten 32 ist mit einem unter Verwendung von Piezokristallen aufgebautem Abstandsstellglied 34 in der Höhe verstellbar. An der dem Prüfkörper 30 zugewandten Seite des Meßkopfhalters 12 sind der Induktionssensor 1, die Düse 13 und die Hallsonde 14 angebracht. Die Hallsonde 14 mißt die Tangentialkomponente des Erregungsmagnetfeldes.

Auf der dem Prüfkörper 30 abgewandten Seite des Meßkopfhalters 12 führt eine Kompressoreinheit 35 über das Rohr 18 der Düse 13 Luft zu. Die in der Kompressoreinheit 35 erzeugte Druckluft tritt aus der Düse 13 in Richtung der Prüfkörperoberfläche aus. Ein im inneren Randbereich des Rohres 18 angebrachter statischer Druckmesser 35' beaufschlagt einen Regler 36 mit einem durch die Düse durchtretenden Luftvolumen pro Zeiteinheit entsprechenden Meßwert. Bei Abweichungen von dem gewählten Sollwert von beispielsweise 0,9 Mikrometer gibt der Regler 36 ein Signal an einen Spannungsgenerator 37. Der Spannungsgenerator 37 beaufschlagt den Piezokristall des Abstandsstellgliedes 34 mit einer entsprechenden Spannung, so daß der tatsächliche Abstand dem vorgewählten Meßabstand angleichbar ist.

Die Ausgangsspannung des Induktionssensors 1 beaufschlagt eine Verstärker- und Filtereinheit 38. In der Verstärker- und Filtereinheit 38 sind ein Vorverstärker mit Hochpaß, eine Hauptverstärkerstufe und Bandpässe integriert. Die Bandpässe sind so ausgelegt, daß die Mittenfrequenz der Verstärker- und Filtereinheit 38 im wesentlichen mit der Resonanzfrequenz des Induktionssensors 1 übereinstimmt. Dadurch ist ein maximales Barkhausenrauschsignal erreichbar. Es kann aber auch zweckmäßig sein, den Wert der Mittenfrequenz in einem Bereich um die Resonanzfrequenz zu verändern.

Die Ausgangsspannung der Hallsonde 14 beaufschlagt einen Meßwandler 39, der die gemessene Hallspannung in einen Meßwert für die Erregungsmagnetfeldstärke umwandelt. Die Ausgangssignale der Verstärker- und Filtereinheit 38 und des Meßwandlers 39 speisen einen Zwischenspeicher 40. Der Zwischenspeicher 40 speichert getaktet paarweise die anliegenden Signale, die jeweils der Stärke des Barkhausenrauschsignals bei einer bestimmten Erregungsmagnetfeldstärke entsprechen.

Ist der gewünschte Bereich des Erregungsmagnetfeldes einmal vollständig durchfahren, gibt der Zwischenspeicher 40 die der Barkhausenrauschkurve entsprechenden Meßgrößenpaare über die Ausgangsleitung an einen Diskriminator 41 weiter. Der Diskriminator 41 bestimmt aus der punktweise bestimmten Barkhausenrauschkurve einen charakteristischen Wert, beispielsweise das Maximum des Barkhausenrauschsignals. Dieser Wert beaufschlagt über die Ausgangsleitung des Diskriminators 41 einen Mittelwertrechner 42. Der Mittelwertrechner 42 summiert eine bestimmte Anzahl von diskriminierten Werten auf und dividiert die Summe durch die Anzahl der Summenglieder. Durch diese Mittelung ist insbesondere bei schwachen Signalen der statistische Fehler der diskriminierten Werte verringerbar. Der Ausgangswert des Mittelwertrechners 42 beaufschlagt einen von zwei Eingängen einer Endspeichereinheit 43.

Eine Positioniersteuereinheit 44 beaufschlagt die Motorsteuerungen 26, 26' mit Steuersignalen zum Verfahren der Montageplatte 24. Eine weitere Ausgangsleitung der Positionssteuereinheit 44 gibt eine der Position der Montageplatte 24 entsprechende Größe an den zweiten Eingang der Endspeichereinheit 43. Die Endspeichereinheit 43 speichert den Ausgangswert des Mittelwertrechners 42 mit der Positionsgröße aus der Positioniersteuereinheit 44 ab.

Nach dem Abspeichern der Position und des Mittelwertes der aus den gemessenen Barkhausenrauschkurven bestimmten charakteristischen Werte ergeht von der Endspeichereinheit 43 ein Impuls zu der Positioniersteuereinheit 44, der ein Verfahren der Montageplatte 24 zu einer neuen Position auslöst. Danach ergeht von der Endspeichereinheit 43 ein Löschsignal an den Mittelwertrechner 42, der den Summenwert auf Null setzt.

Die Messung ist beendet, wenn alle gewünschten Positionen angefahren und in der Endspeichereinheit 43 die entsprechenden Positionsgrößen aus der Positionssteuereinheit 44 mit den zugehörigen Ausgangswerten des Mittelwertrechners 42 abgespeichert sind. Der Inhalt der Endspeichereinheit 43 ist über ein an diese angeschlossenes Ausgabegerät 45, beispielsweise einem Bildschirm, darstellbar. Als Ausgabegerät sind selbstverständlich beispielsweise auch Drucker verwendbar. Die Darstellung der Verteilung der diskriminierten Werte über die untersuchte Prüfkörperoberfläche ist vorzugsweise flächig in Farbdarstellung ausgeführt. Die Meßwertverteilung kann aber auch beispielsweise in Grauwertdarstellung oder in dreidimensionaler Graphik ausgegeben werden.

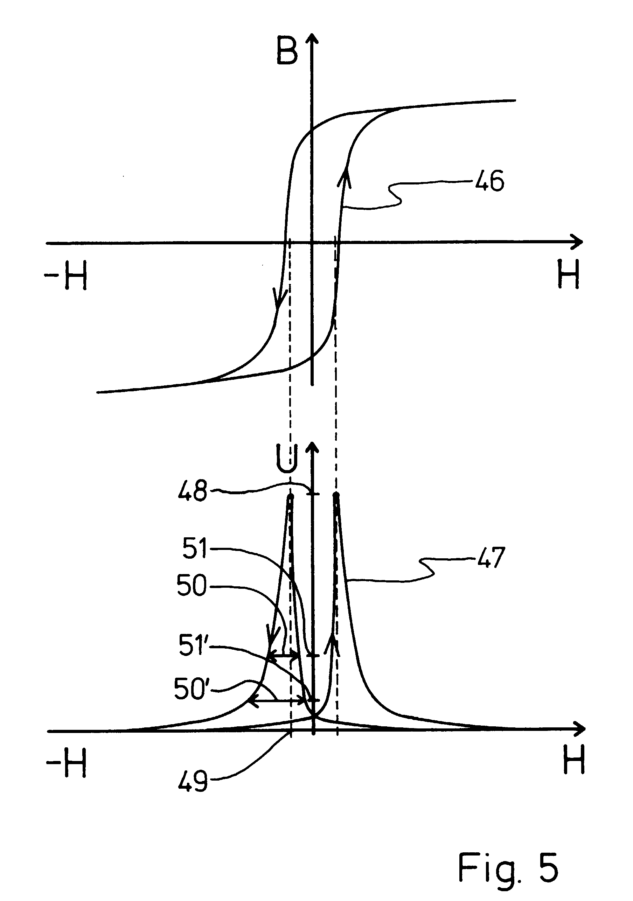

Fig. 5 zeigt beispielhaft eine Hysteresekurve B(H) 46 beim Durchfahren des Erregungsmagnetfeldes H und eine zugehörige Einhüllende U(H) 47 einer magnetischen Barkhausenrauschkurve. Die Barkhausenrauschkurve wird durch bei der Ummagnetisierung sprunghaft auftretende Verschiebungen der die Weiß'schen Bezirke begrenzenden Blochwände erzeugt. Durch die Blochwandverschiebungen wird ein breitbandiges Spektrum von Wirbelströmen hervorgerufen. Diese Wirbelströme führen Magnetfelder mit sich, die wiederum in dem Induktionssensor 1 über induzierte Spannungen detektierbar sind. Weiterhin sind Streufelder der Blochwandabschlußbereichsstruktur, die sich bei der Bewegung der Blochwände an der Oberfläche verändern, mit dem Induktionssensor 1 nachweisbar.

Die Spannungen weisen sehr starke Fluktuationen sowie eine große Frequenzbandbreite auf. Bei höherer Auflösung zeigt auch die Hysteresekurve sprunghafte Änderungen. In den bei verschiedenen Analysierfrequenzen aufgenommenen Barkhausenrauschkurven sind gegenüber der Hysteresekurve zusätzliche bzw. ergänzende Informationen über das Gefüge des Prüfkörpers enthalten. Beispielsweise stimmt im allgemeinen das Maximum der Einhüllenden 47 der Barkhausenrauschkurve nicht mit der Koerzitivfeldstärke der Hysteresekurve 46 überein, wenn mehrere ferromagnetische Phasen, zum Beispiel Ferrit und Zementit, im Gefüge vorliegen.

Die Barkhausenrauschkurve ist nicht nur materialabhängig, sondern auch von dem Makro- und Mikrospannungszustand des Prüfkörpers beeinflußt. Je nach mechanischem Spannungszustand und Material ändert sich die durch den Induktionssensor 1 erfaßte elektrische Maximalspannung 48, die dabei herrschende Erregungsmagnetfeldstärke 49 und die Breiten 50, 50' der Einhüllenden 47 der Barkhausenrauschkurve an bestimmten Relativspannungen 51, 51'.

In einem Prüfkörper 30, der beispielsweise Zementitlamellen in einer Ferritmatrix aufweist, ist die Maximalspannung 48 der Barkhausenrauschkurve am Ort von Zementitlamellen gegenüber Ferritbereichen herabgesetzt, da Zementit eine kleinere Rauschamplitude aufweist sowie zusätzlich unter einer die elektrische Maximalspannung 48 verringernden Druckeigenspannung steht, während demgegenüber Ferrit stärker rauscht und einer unter die elektrische Maximalspannung 48 heraufsetzenden Zugeigenspannung steht.

Als charakteristischer Wert für die Diskriminierung ist vorzugsweise die elektrische Maximalspannung 48 der Einhüllenden 47 der Barkhausenrauschkurve geeignet. Als ein weiterer charakteristischer Wert kann auch die Stärke 49 des Erregungsmagnetfeldes H bei der elektrischen Maximalspannung 48 dienen. Als weitere charakteristische Größen können jeweils die Breiten 50, 50' der Einhüllenden 47 der Barkhausenrauschkurve an den zugehörigen Relativspannungen 51, 51' herangezogen werden.

Mit diesen Meßgrößen läßt sich ein Bild des Makro- und Mikrospannungszustandes der Oberfläche des Prüfkörpers erzeugen.

Die Wirbelstromausbreitung ist exponentiell mit dem Ausbreitungsweg gedämpft. Die Dämpfungskonstante ist proportional der Wurzel aus der Frequenz der Wirbelströme. Durch die Wahl der Mittenfrequenz und der Bandbreite der Detektionsvorrichtung für das magnetische Barkhausenrauschen, bestehend aus dem Induktionssensor 1 und der Verstärker- und Filtereinheit 38, ist die Analysiertiefe variierbar. Rauschsignale mit hoher Frequenz stammen vorwiegend aus sehr oberflächennahen Bereichen, während in Signalen mit niedriger Frequenz auch Beiträge aus tieferliegenden Schichten enthalten sind. Die Analysiertiefe ist im wesentlichen umgekehrt proportional zu der gewählten Analysierfrequenz und weiterhin parametrisch von Materialkonstanten sowie von der Bauform des Induktionssensors 1 abhängig.

Vorteilhafterweise weist die Positioniervorrichtung 22 einen großen Verstellweg auf, so daß der untersuchte Bereich der Oberfläche des Prüfkörpers 30 mit einer der Ortsauflösung des Induktionssensors 1 entsprechenden Genauigkeit an die Meßorte von beispielsweise einem Lichtmikroskop, einer Ultraschall- oder Röntgenmeßeinrichtung verfahrbar ist. Dadurch kann genau der mikromagnetisch untersuchte Bereich des Prüfkörpers 30 mit weiteren Meßvorrichtungen, die der mikromagnetischen Analyse nicht zugängliche Größen bestimmen, ohne Verlust der Ortsreferenz oder an Ortsauflösung untersucht werden.

In einem in der Zeichnung nicht dargestellten Ausführungsbeispiel sind der Erregungsmagnet 27 und mittig zwischen den beiden Schenkeln des U-förmigen Jochs 28 der Induktionssensor 1, die Luftdüse 13 und die Hallsonde 14 in einem feststehenden Integralmeßkopf vereint, der auf der Positioniereinheit angebracht ist. Der Prüfkörper ist an dem senkrecht zur Ebene der Positioniereinheit 22 verfahrbaren Schlitten 32 des Verschiebetisches 33 befestigt. Die Messung erfolgt analog wie in dem in Fig. 4 dargestellten Ausführungsbeispiel, indem der Integralmeßkopf verfahren wird.

In einem weiteren Ausführungsbeispiel sind an dem Meßkopfhalter 12 zwei Induktionssensoren mit verschiedenen Resonanzfrequenzen in einem festen Abstand voneinander befestigt. Die empfangsaktiven Bereiche der beiden Induktionssensoren und das Ende der Düse 13 liegen im wesentlichen in einer Ebene. Die Ausgangsleitungen der beiden Induktionssensoren beaufschlagen mit bis auf die Positioniersteuervorrichtung verschiedenen Meßdatenerfassungseinrichtungen, jeweils bestehend aus einer Verstärker- und Filtereinheit 38, einem Meßwandler 39, einem Zwischenspeicher 40, einem Diskriminator 41, einem Mittelwertrechner 42 und einem Endspeicher 43. Die Positioniervorrichtung 44 weist zwei Ausgangsleitungen zu den beiden Endspeichern auf und verfährt die Montageplatte 24 erst nach Erhalt von zwei Verfahrimpulsen aus den beiden Endspeichern. Die beiden Induktionssensoren sind in einem Meßzyklus jeweils an gleichen Positionen des zu untersuchenden Oberflächenbereiches positionierbar.

Die beiden Verstärker- und Filtereinheiten 38 sind auf verschiedene, an den jeweils angeschlossenen Induktionssensor angepaßte Mittenfrequenzen eingestellt. In diesem Ausführungsbeispiel sind gleichzeitig zwei mit verschiedenen Analysierfrequenzen aufgenommene Bilder erhältlich, so daß ein mit Verlust an Reproduzierbarkeit behafteter Wechsel der Induktionssensoren für verschiedene Analysierfrequenzen nicht erforderlich ist.

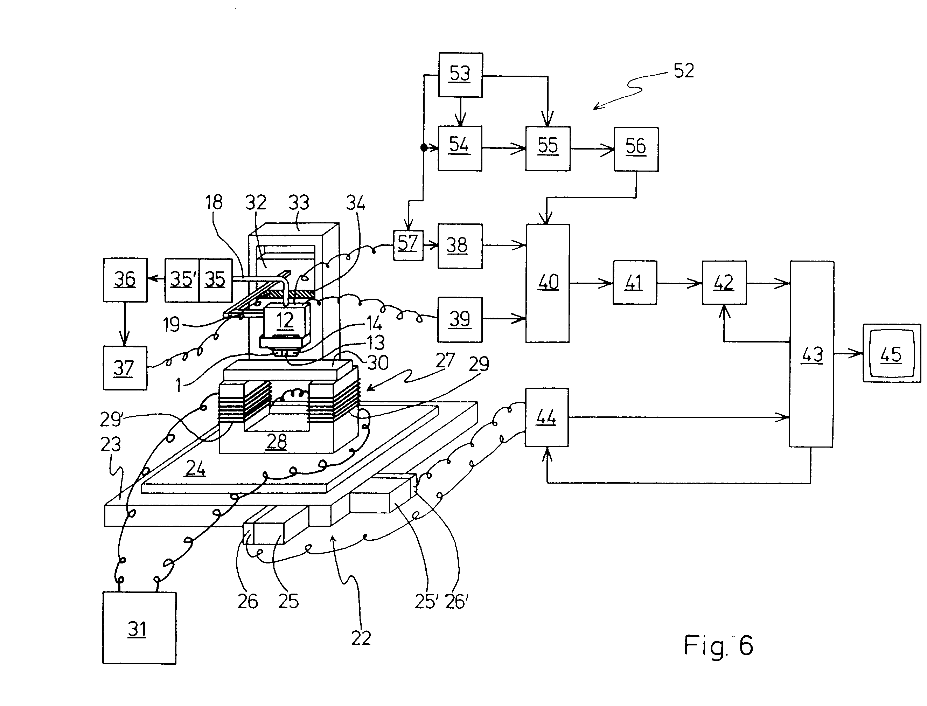

Fig. 6 zeigt in einer schematischen Darstellung eine Vorrichtung zum ortsaufgelösten Untersuchen von magnetischen Kenngrößen gemäß der in Fig. 4 dargestellten Vorrichtung, bei der weiterhin eine Impedanzmeßvorrichtung 52 vorgesehen ist. Die Impedanzmeßvorrichtung 52 weist einen Hochfrequenzgenerator 53 auf, dessen Ausgangssignal den Induktionsspulen 11, 11' einspeisbar ist. Die von dem Hochfrequenzgenerator 53 den Induktionsspulen 11, 11' zugeführte Frequenz ist in diesem Ausführungsbeispiel etwa um einen Faktor 100 höher als die von dem Wechselstromgenerator 31 erzeugte Frequenz und beträgt etwa 10 Megahertz. Durch den großen Frequenzunterschied zwischen dem Wechselstromgenerator 31 und dem Hochfrequenzgenerator 53 ist gewährleistet, daß über mehrere Perioden der von dem Hochfrequenzgenerator 53 in den Induktionssensor 1 eingespeisten Frequenz das den Prüfkörper 30 durchsetzende Magnetfeld im wesentlichen konstant ist.

Durch die sehr kleinen Abmessungen des Einkoppelspaltes 5 ist im Vergleich zu den über die Spulen 29, 29' des Erregungsmagnetes 27 erzeugten großflächigen niederfrequenten Wirbelströmen örtlich sehr begrenzte hochfrequente Wirbelströme geringer Stärke in den Prüfkörper 30 einprägbar. Die Eindringtiefe der Wirbelströme ist von der von dem Hochfrequenzgenerator 53 eingespeisten Frequenz abhängig.

Die eingespeisten Wirbelströme erzeugen ein Magnetfeld, dessen Stärke von der Permeabilität und der Leitfähigkeit des Prüfkörpers 30 abhängen. Die hochfrequenten wirbelstrominduzierten Magnetfelder sind über den Induktionssensor 1 einem Hochfrequenzkomparator 54 einspeisbar. Der Hochfrequenzkomparator 54 ist weiterhin von dem durch den Hochfrequenzgenerator 53 erzeugten Signal beaufschlagt. Mit dem Hochfrequenzkomparator 54 ist der durch die wirbelstrominduzierten Magnetfelder gebildete Anteil des Ausgangssignales des Induktionssensors 1 von dem Signal des Hochfrequenzgenerators 53 abtrennbar.

Das Ausgangssignal des Hochfrequenzkomparators 54 ist einem Demodulator 55 zugeführt, dem ebenfalls das Ausgangssignal des Hochfrequenzgenerators 53 eingespeist ist. Mit dem Demodulator 55 ist durch Multiplikation des Ausgangssignales des Hochfrequenzkomparators 54 mit der Sinusfunktion und Kosinusfunktion des von dem Hochfrequenzgenerators 53 gelieferten Frequenz der Realteil und Imaginärteil der Wirbelstromimpedanz des Induktionssensors 1 erzeugbar. Das Ausgangssignal des Demodulators 55 ist über einen Niederfrequenzkomparator 56 zum Einstellen des Arbeitspunktes auf einen Referenzwert dem Zwischenspeicher 40 zugeführt. Die Endspeichereinheit 43 speichert den Wert der Wirbelstromimpedanz in Abhängigkeit der Position des Induktionssensors 1 nach Diskriminierung und Mittelung der Impedanzmeßwerte in dem Diskriminator 41 und dem Mittelwertrechner 42 ab.

In dem in Fig. 6 dargestellten Ausführungsbeispiel ist mittels eines Betriebswahlschalters 57 entweder die Messung von Barkhausenrauschkurven oder von Impedanzen einstellbar. In einer gegenüber dem Ausführungsbeispiel gemäß der Fig. 6 modifizierten, nicht dargestellten Ausführungsform ist mittels der Endspeichereinheit 43 an einer Meßposition des Induktionssensors 1 nacheinander in die beiden Betriebsarten schaltbar, so daß in einem Meßzyklus ortsaufgelöst sowohl Barkhausenrauschkurven als auch Impedanzen ohne aufwendige Nachjustierarbeiten an jeweils den gleichen Meßpositionen erfaßbar sind.

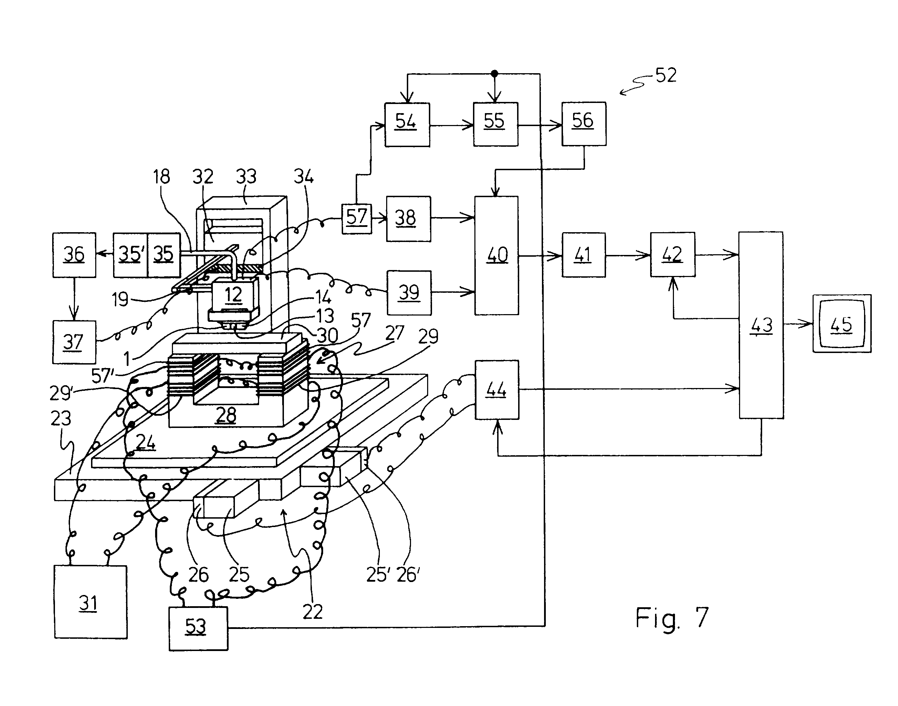

Fig. 7 zeigt in einem gegenüber der Fig. 6 abgewandelten Ausführungsbeispiel eine Vorrichtung, bei der an den Hochfrequenzgenerator 53 der Impedanzmeßvorrichtung 52 eine auf dem Joch 28 des Erregungsmagneten 27 aufgebrachte Hochfrequenzspulen 57, 57' angeschlossen sind. In diesem Ausführungsbeispiel erfolgt die Einprägung des hochfrequenten Magnetfeldes über den Erregungsmagneten 27 großflächig in den gesamten Prüfkörper 30. Dieses Ausführungsbeispiel ist dafür vorgesehen, die großflächige Verteilung von über die Enden des Prüfkörpers 30 eingeprägten hochfrequenten Wirbelströmen in einem quasistatischen Magnetfeld und damit die Überlagerungspermeabilität zu bestimmen.

## Patentansprüche

1. Vorrichtung zum ortsaufgelösten, zerstörungsfreien Untersuchen von magnetischen Kenngrößen eines Prüfkörpers (30) mit einem mit einer Positioniervorrichtung (22) in einem Abstand in bezug auf den Prüfkörper (30) positionierbaren Induktionssensor (1), der aus einem ferromagnetischen Kern (2) mit zwei Kernteilen (3, 3') und mindestens einer Induktionsspule (11, 11') aufgebaut ist, wobei die Kernteile (3, 3') des Induktionssensors (1) wenigstens im äußeren Mündungsbereich eines mit einem Einkoppelspalt (5) ausgebildeten Einkoppelbereiches spitzenartig zulaufen, **dadurch gekennzeichnet,** daß die Abmessungen des Einkoppelspaltes (5) höchstens im Bereich der Dimension von zu untersuchenden, durch Blochwände begrenzten Mikrostrukturen des Prüfkörpers (30) liegen, daß ein Abstandsmesser zum Messen des Abstandes zwischen dem Induktionssensor (1) und der Oberfläche des Prüfkörpers (30) vorgesehen ist, daß ein Abstandsstellglied (34) vorgesehen ist, mit dem der Abstand zwischen dem Induktionssensor (1) und der Oberfläche des Prüfkörpers (30) durch Beaufschlagen mit dem Ausgangssignal eines Reglers (36) beim Positionieren des Induktionssensors (1) konstanthaltbar ist, daß ein Erregungsmagnet (27) und ein Wechselstromgenerator (31) vorgesehen sind, mit denen ein Erregungsmagnetfeld generierbar ist, welches den Prüfkörper zum Erzeugen großflächiger, niederfrequenter Wirbelströme durchsetzt, daß eine Impedanzmeßvorrichtung (52) vorgesehen ist, die einen Hochfrequenzgenerator (53) umfaßt, welcher gegenüber dem Erregungsmagnetfeld hochfrequentere, wirbelstrominduzierte Magnetfelder erzeugen kann, die über den Einkoppelspalt (5) aufnehmbar sind, daß ein Speicher (40) und ein Diskriminator (41) zur Bestimmung wenigstens eines für eine aufgenommene Barkhausenrauschkurve charakteristischen Wertes vorgesehen sind und daß die Impedanzmeßvorrichtung (52) über eine von den höherfrequenten, wirbelstrominduzierten Magnetfeldern gespeiste Auswerteeinheit (54, 55, 56) verfügt, mit der die von der Permeabilität und der Leitfähigkeit des Prüfkörpers (30) abhängige Wirbelstromimpedanz erfaßbar ist.

2. Vorrichtung nach Anspruch 1, dadurch gekennzeichnet, daß im Bereich des Einkoppelspaltes (5) jeder Kernteil (3, 3') beidseitig des Einkoppelspaltes (5) wenigstens einen von jedem Kernteil (3, 3') wegweisenden Kernteilvorsprung (7, 7') aufweist.

3. Vorrichtung nach Anspruch 1 oder 2, dadurch gekennzeichnet, daß das dem Einkoppelspalt (5) gegenüberliegende Spaltende als Rückschlußspalt (6) mit verfüllten Ausnehmungen (8, 8') in beiden Kernteilen (3, 3') ausgebildet ist.

4. Vorrichtung nach Anspruch 3, dadurch gekennzeichnet, daß die Ausnehmungen (8, 8') mit Glas verfüllt sind.

5. Vorrichtung nach einem der Ansprüche 1 bis 4, dadurch gekennzeichnet, daß jeder Kernteil (3, 3') Ausnehmungen (9, 10, 10') zum Aufnehmen von Wicklungen der Induktionsspule (11, 11') aufweist.

6. Vorrichtung nach einem der Ansprüche 1 bis 5, dadurch gekennzeichnet, daß die Kernteile (3, 3') des Induktionssensors (1) aus Ferrit sind.

7. Vorrichtung nach einem der Ansprüche 1 bis 6, dadurch gekennzeichnet, daß der Induktionssensor (1) von einem Abschirmgehäuse aus einer Metallegierung mit einer hohen Anfangspermeabilität und einer kleinen Koerzitivkraft, insbesondere aus Mumetall, umgeben ist, wobei der äußere Mündungsbereich des Einkoppelspaltes (5) freiliegend ist.

8. Vorrichtung nach einem der Ansprüche 1 bis 7, dadurch gekennzeichnet, daß der Abstandsmesser aus einer druckluftdurchströmten, auf die Prüfkörperoberfläche (30) gerichtete Düse (13) und einem statischen Druckmesser (35') besteht, wobei mit dem statischen Druckmesser (35') der statische Druck in einem Zuleitungsrohr (18) zu der Düse (13) meßbar ist.

9. Vorrichtung nach einem der Ansprüche 1 bis 8, dadurch gekennzeichnet, daß das Abstandsstellglied (34) mindestens einen Piezokristall aufweist.

10. Vorrichtung nach einem der Ansprüche 1 bis 9, dadurch gekennzeichnet, daß zum Erzeugen der hochfrequenten wirbelstrominduzierten Magnetfelder die Induktionsspulen (11, 11') des Induktionssensors (1) an den Hochfrequenzgenerator (53) angeschlossen sind.

11. Vorrichtung nach einem der Ansprüche 1 bis 9, dadurch gekennzeichnet, daß zum Erzeugen der hochfrequenten wirbelstrominduzierten Magnetfelder Spulen (57, 57') des Erregungsmagneten (27) an den Hochfrequenzgenerator (53) angeschlossen sind.

## Claims

1. Apparatus for the positionally resolved non-destructive investigation of magnetic parameters of a test body (30) having an induction sensor (1) which can be positioned with a positioning means (22) at a spacing with respect to the test body (30) and which is made up of a ferromagnetic core (2) with two core portions (3, 3') and at least one induction coil (11, 11'), wherein the core portions (3, 3') of the induction sensor (1) converge in a point-like configuration at least in the outer mouth region of a coupling-in region which is formed with a coupling-in gap (5), characterised in that the dimensions of the coupling-in gap (5) are at most in the region of the dimension of microstructures (30) to be investigated, which are defined by Bloch walls, of the test body (30), that there is provided a spacing measuring means for measuring the spacing between the induction sensor (1) and the surface of the test body (30), that there is provided a spacing adjusting member (34) with which the spacing between the induction sensor (1) and the surface of the test body (30) can be kept constant by actuation with the output signal of a regulator (36) when positioning the induction sensor (1), that there are provided an excitation magnet (27) and an ac generator (31) with which there can be generated an excitation magnetic field which passes through the test body to produce large-area, low-frequency eddy currents, that there is provided an impedance measuring means (52) including a high frequency generator (53) which can produce eddy current-induced magnetic fields which are of higher frequency than the excitation magnetic field and which can be picked up by way of the coupling-in gap (5), that there are provided a memory means (40) and a discriminator (41) for determining at least one value which is characteristic of a picked-up Barkhausen noise curve, and that the impedance measuring means (52) has an evaluation unit (54, 55, 56) which is fed by the higher-frequency, eddy current-induced magnetic fields and with which the eddy current impedance which is dependent on the permeability and the conductivity of the test body (30) can be detected.

2. Apparatus according to claim 1 characterised in that in the region of the coupling-in gap (5) each core portion (3, 3') has on both sides of the coupling-in gap (5) at least one coupling portion projection (7, 7') which faces away from each core portion (3, 3').

3. Apparatus according to claim 1 or claim 2 characterised in that the gap end which is opposite to the coupling-in gap (5) is in the form of a return gap (6) with filled recesses (8, 8') in both core portions (3, 3').

4. Apparatus according to claim 3 characterised in that the recesses (8, 8') are filled with glass.

5. Apparatus according to one of claims 1 to 4 characterised in that each core portion (3, 3') has recesses (9, 10, 10') for receiving windings of the induction coil (11, 11').

6. Apparatus according to one of claims 1 to 5 characterised in that the core portions (3, 3') of the induction sensor (1) are of ferrite.

7. Apparatus according to one of claims 1 to 6 characterised in that the induction sensor (1) is enclosed by a shielding housing comprising a metal alloy with a high level of initial permeability and a low coercive force, in particular Mumetal, wherein the outer mouth region of the coupling-in gap (5) is exposed.

8. Apparatus according to one of claims 1 to 7 characterised in that the spacing measuring means comprises a nozzle (13) through which flows compressed air and which is directed on to the test body surface (30), and a static manometer (35'), wherein the static pressure in a feed tube (18) to the nozzle (13) can be measured with the static manometer (35').

9. Apparatus according to one of claims 1 to 8 characterised in that the spacing adjusting member (34) has at least one piezoelectric crystal.

10. Apparatus according to one of claims 1 to 9 characterised in that to produce the high-frequency, eddy current-induced magnetic fields, the induction coils (11, 11') of the induction sensor (1) are connected to the high frequency generator (53).

11. Apparatus according to one of claims 1 to 9 characterised in that to produce the high-frequency, eddy current-induced magnetic fields, coils (57, 57') of the excitation magnet (27) are connected to the high frequency generator (53).

## Revendications

1. Dispositif pour examiner de manière non destructive et avec une résolution spatiale des grandeurs caractéristiques magnétiques d'une éprouvette (30), comportant un capteur à induction (1), pouvant être positionné à distance par rapport à l'éprouvette (30) par un dispositif de positionnement (22) et qui est constitué par un noyau ferromagnétique (2) comportant deux parties (3, 3') et au moins une bobine d'induction (11, Il'), et dans lequel les parties (3, 3') du noyau convergent en forme de pointe au moins dans la zone extérieure de l'embouchure d'une zone de couplage réalisée avec une fente de couplage (5), caractérisé en ce que les dimensions de la fente de couplage (5) se situent au maximum au voisinage de la dimension de microstructures à examiner, qui sont limitées par des parois de Bloch, de l'éprouvette (30), qu'il est prévu un appareil de mesure de distance pour mesurer la distance entre le capteur à induction (1) de la surface de l'éprouvette (30), qu'il est prévu un organe (34) de réglage de distance, au moyen duquel la distance entre le capteur à induction (1) et la surface de l'éprouvette (30) peut être maintenue constante sous l'effet d'une charge avec le signal de sortie d'un régulateur (36) lors du positionnement du capteur à induction (1), qu'il est prévu un aimant d'excitation (27) et un générateur de courant alternatif (31), à l'aide desquels peut être produit un champ magnétique d'excitation, qui traverse l'éprouvette pour produire des courants de Foucault à basse fréquence, s'étendant sur une surface étendue, qu'il est prévu un appareil de mesure d'impédance (52), qui comporte un générateur de hautes fréquences (53) qui peut produire des champs magnétiques à fréquence plus élevée que celle du champ magnétique d'excitation, induits par des courants de Foucault et qui peuvent être captés au-dessus de la fente de couplage (5), qu'il est prévu une mémoire (40) et un discriminateur (41) pour déterminer au moins une valeur caractéristique pour une courbe de bruit de Barkhausen, et que le dispositif de mesure d'impédance (52) dispose d'une unité d'exploitation (54, 55, 56), qui est alimentée par les champs magnétiques à fréquence supérieure, induits par les courants de Foucault et au moyen duquel l'impédance avec les courants de Foucault, qui dépend de la perméabilité et de la conductibilité de l'éprouvette (30), peut être détectée.

2. Dispositif selon la revendication 1, caractérisé en ce que dans la zone de la fente de couplage (5), chaque partie (3, 3') du noyau comporte, des deux côtés de la fente de couplage (5), au moins un appendice saillant (7, 7') qui est tourné à l'opposé de chaque partie (3, 3') du noyau.

3. Dispositif selon la revendication 1 ou 2, caractérisé en ce que l'extrémité de la fente, qui est située à l'opposé de la fente de couplage (5), est agencée sous la forme d'une fente (6) de fermeture du flux, qui comporte des évidements remplis (8, 8'), situés dans les deux parties (3, 3') du noyau.

4. Dispositif selon la revendication 3, caractérisé en ce que les évidements (8, 8') sont remplis de verre.

5. Dispositif selon l'une des revendications 1 à 4, caractérisé en ce que chaque partie (3, 3') du noyau comporte des évidements (9, 10, 10') servant à loger des enroulements de la bobine d'induction (11, 11').

6. Dispositif selon l'une des revendications 1 à 5, caractérisé en ce que les parties (3, 3') du noyau du capteur à induction (1) sont formées de ferrite.

7. Dispositif selon l'une des revendications 1 à 6, caractérisé en ce que le capteur à induction (1) est entouré par une enceinte de blindage formée d'un alliage métallique possédant un haute perméabilité initiale et une faible force coercitive, notamment du mumétal, la zone d'embouchure extérieure de la fente de couplage (5) étant dégagée.

8. Dispositif selon l'une des revendications 1 à 7, caractérisé en ce que l'appareil de mesure de distance est constitué par une buse (13) qui est traversée par de l'air comprimé et est dirigée vers la surface (30) de l'éprouvette, et par un manomètre statique (35'), la pression statique dans une conduite tubulaire d'amenée (18) aboutissant à la buse (13) pouvant être mesurée au moyen du manomètre statique (35').

9. Dispositif selon l'une des revendications 1 à 8, caractérisé en ce que l'organe (34) de réglage de distance comporte au moins un cristal piézoélectrique.

10. Dispositif selon l'une des revendications 1 à 9, caractérisé en ce que pour la production des champs magnétiques à haute fréquence, induits par les courants alternatifs, les bobines d'induction (11, 11') du capteur à induction (1) sont raccordées au générateur de hautes fréquences (53).

11. Dispositif selon l'une des revendications 1 à 9, caractérisé en ce que pour la production des champs magnétiques à haute fréquence, induits par les courants de Foucault, des bobines (57, 57') de l'aimant d'excitation (27) sont connectées au générateur de hautes fréquences (53).
